Europäisches Patentamt

(19) European Patent Office

Office européen des brevets

(11) Veröffentlichungsnummer: **0 249 270 B1**

(12) **EUROPÄISCHE PATENTSCHRIFT**

(45) Veröffentlichungstag der Patentschrift:
21.08.91 Patentblatt 91/34

(51) Int. Cl.⁵: **H03K 7/08**

(21) Anmeldenummer: **87200977.4**

(22) Anmeldetag: **27.05.87**

(54) **Pulsbreitenmodulator.**

(30) Priorität: **09.06.86 DE 3619353**

(43) Veröffentlichungstag der Anmeldung:
**16.12.87 Patentblatt 87/51**

(45) Bekanntmachung des Hinweises auf die
Patenterteilung:
**21.08.91 Patentblatt 91/34**

(84) Benannte Vertragsstaaten:
**DE ES FR GB IT NL SE**

(56) Entgegenhaltungen:
**DE-A- 1 925 814**
**DE-A- 2 404 286**
**DE-A- 2 915 882**
**DE-C- 3 227 296**

(73) Patentinhaber: **Philips Patentverwaltung**
**GmbH**
**Wendenstrasse 35 Postfach 10 51 49**
**W-2000 Hamburg 1 (DE)**
**DE**
Patentinhaber: **N.V. Philips'**
**Gloeilampenfabrieken**
**Groenewoudseweg 1**
**NL-5621 BA Eindhoven (NL)**
**ES FR GB IT NL SE**

(72) Erfinder: **Riedger, Thomas, Dipl.-Ing.**
**Grossgeschaidter Strasse 28**
**W-8501 Eckental (DE)**

(74) Vertreter: **Peuckert, Hermann, Dipl.-Ing.**
**Philips Patentverwaltung GmbH**
**Wendenstrasse 35 Postfach 10 51 49**
**W-2000 Hamburg 1 (DE)**

## Beschreibung

Die Erfindung betrifft einen Pulsbreitenmodulator, bei dem durch ein Gatter eine Rechteckschwingung mit festem Tastverhältnis und fester Frequenz proportional zur Größe eines Eingangssignals pulsbreitenmoduliert wird.

Pulsbreitenmodulatoren werden z.B. bei getakteten und geregelten Gleichspannungswandlern eingesetzt, bei denen sie eine als Stellgröße vorliegende analoge Spannung in ein Rechtecksignal mit variablem Tastverhältnis umsetzen. Mit dem pulsbreitenmodulierten Signal wird der Schalttransistor des Wandlers entsprechend den Impulslängen geöffnet oder geschlossen.

Aus der deutschen Patentschrift DE-C- 32 27 296 ist ein Pulsbreitenmodulator bekannt, der aus einem Sägezahnoszillator, zwei Komparatoren, einem UND-Gatter und aus Verstärkern besteht. Durch den einen Komparator wird das analoge Eingangssignal mit der Sägezahnspannung und durch den anderen Komparator wird die Sägezahnspannung mit einer zeitlichen konstanten Spannung verglichen. Die zeitlich konstante Spannung wird mit einem Spannungsteiler aus der Versorgungsspannung erzeugt. Die Ausgangsspannungen der Komparatoren sind an die Eingänge des UND-Gatters geführt, dessen Ausgangssignal das pulsbreitenmodulierte Signal darstellt. Das Tastverhältnis des Ausgangsignales variiert - je nach Amplitude des kontinuierlichen Eingangssignales - zwischen einem durch den Spannungsteiler einstellbaren Maximalwert und dem Wert Null.

Da der bekannte Pulsbreitenmodulator zwei Komparatoren mit kurzen Durchlaufverzögerungszeiten und einen Sägezahngenerator mit linearer Rampenspannung benötigt und diese Bausteine aus bipolaren Transistoren aufgebaut sind, weist er eine relativ große Verlustleistung auf. Er ist daher z.B. für den Einsatz in getakteten Gleichspannungswandlern mit einer Schaltfrequenz von etwa 20 kHz ungeeignet, wenn die zusätzliche Forderung nach extrem geringen Eigenverlusten gestellt wird.

Der Erfindung liegt die Aufgabe zugrunde, einen Pulsbreitenmodulator der eingangs genannten Art anzugeben, der mit schnellen und extrem verlustarmen Bausteinen realisiert werden kann.

Diese Aufgabe wird dadurch gelöst, daß eine nachtriggerbare, monostabile Kippschaltung vorgesehen ist, deren Zeitglied aus einem Kondensator besteht, der von einer durch das Eingangssignal gesteuerten Stromquelle aufgeladen wird, daß der Ausgang eines Rechteckgenerators mit dem Triggereingang der Kippschaltung und mit einem Eingang des Gatters verbunden ist und daß das Ausgangssignal der Kippschaltung an den anderen Eingang des Gatters geführt ist.

Die in der Problemlösung erwähnte monostabile Kippschaltung, der Rechteckgenerator und das UND-Gatter sind als Standard-CMOS-Bausteine erhältlich ; damit ist unter anderem die extrem geringe Eigenverlustleistung gewährleistet. Sie liegt für alle Bausteine zusammen unter 10 mW.

Vorteilhafte Ausgestaltungen der Erfindung sind in den Unteransprüchen angegeben. Anhand der Figuren soll ein Ausführungsbeispiel der Erfindung näher erläutert und beschrieben werden.

Es zeigen :

Fig. 1 eine Schaltung mit Merkmalen nach der Erfindung und

Fig. 2 Impulsdiagramme zur Erläuterung ihrer Wirkungsweise.

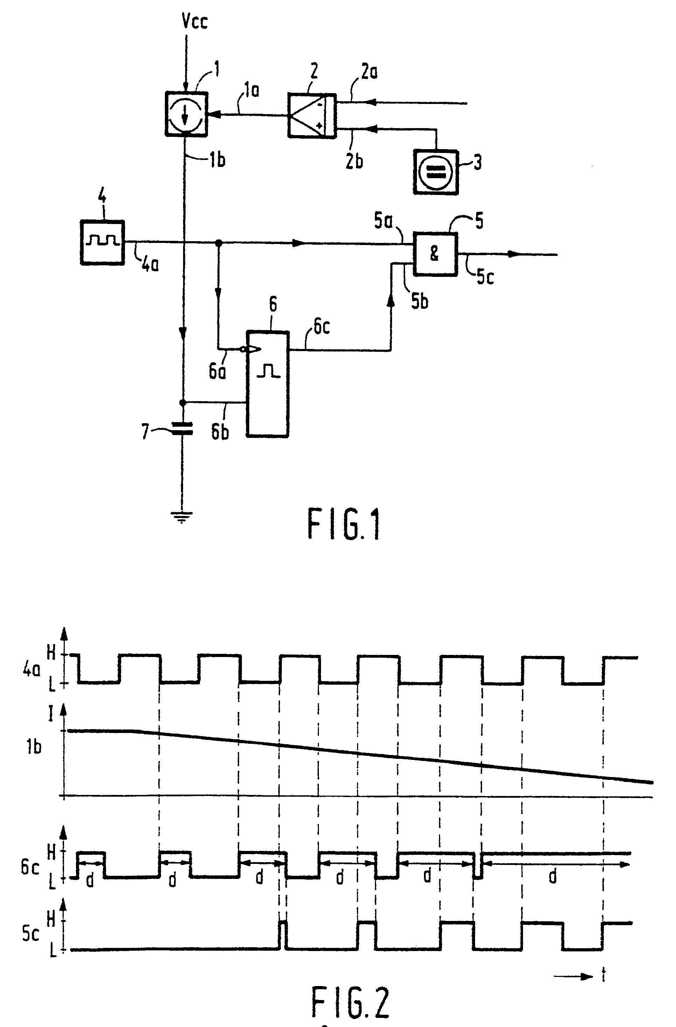

Die wichtigsten Bestandteile der Schaltung nach Fig. 1 sind eine steuerbare Stromquelle 1, ein Rechteckgenerator 4, ein UND-Gatter 5, eine monostabile flankengetriggerte Kippschaltung 6 und ein Kondensator 7. Es werden folgende Bausteine verwendet : Als Rechteckgenerator 4 der CMOS-Timer 7555, als monostabile Kippschaltung 6 der CMOS-Multivibrator MC 14528 B, als steuerbare Stromquelle ein Bipolar-Transistor mit Emitterwiderstand (Tietze, U., Schenk, Ch. : Halbleiter-Schaltungstechnik, 5. Auflage, Springer Verlag Berlin, Heidelberg, New York 1980) und für das UND-Gatter der CMOS-Baustein MC 14011 B.

Über die steuerbare Stromquelle 1 wird der Kondensator 7, dessen eine Elektrode mit dem Ausgang 1b der Stromquelle 1 verbunden ist, aufgeladen. Die andere Elektrode des Kondensators 7 ist auf Bezugspotential gelegt. Der Kondensator 7 und die steuerbare Stromquelle 1 bilden das Zeitglied für die monostabile Kippschaltung 6. Übersteigt die Kondensatorspannung die halbe Betriebsspannung $VCC/2$, so springt der Pegel am Ausgang 6c der Kippschaltung 6 von HIGH auf LOW. Der Kondensator 7 wird - wegen der Verbindung des Ausgangs 4a des Rechteckgenerators 4 mit dem Triggereingang 6a der monostabilen Kippschaltung 6 - mit jeder fallenden (negativen) Flanke der Rechteckschwingung entladen.

Ist der Ladestrom I hinreichend klein, so erreicht die Spannung am Kondensator 7 in der Zeit zwischen zwei Entladevorgängen nicht die halbe Betriebsspannung $VCC/2$ und der Pegel am Ausgang 6c bleibt auf HIGH.

Der Pegel HIGH am Ausgang 6c öffnet - wegen der Verbindung des Ausgangs 6c mit dem Eingang 5b des UND-Gatters 5 - das UND-Gatter 5 für die vollen Impulse des Rechteckgenerators 4, die an einem Eingang 5a des UND-Gatters 5 anliegen. An einem Ausgang 5c tritt folglich eine Rechteckschwingung auf, die das gleiche Tastverhältnis hat, wie die Schwingung des Rechteckgenerators 4 ; in aller Regel hat deren Tastverhältnis den Wert 0,5.

Ist der Ladestrom I für den Kondensator 7 größer, so überschreitet die Kondensatorspannung zwischen zwei Entladungen den halben Wert der Betriebsspannung. Die Folge davon ist, daß der Pegel am Ausgang 6c der monostabilen Kippschaltung 6 auf LOW wechselt und am Ausgang 5 des UND-Gatters 5 die Impulse des Rechteckgenerators verkürzt anstehen, das Tastverhältnis also verkleinert wird. Bei dem größtmöglichen Ladestrom I treten am Ausgang 5c überhaupt keine Impulse mehr auf.

Die Impulsdiagramme der Fig. 2 zeigen die geschilderten Verhältnisse noch einmal genauer. Die Amplituden der binären Signale sind durch ihre Pegel H (HIGH) und L (LOW) symbolisiert. Links von jedem Diagramm ist das Bezugszeichen des Ausganges angegeben, an dem das Signal auftritt. So zeigt das oberste Diagramm die Impulsfolge am Ausgang 4a des Rechteckgenerators 4. Das nächstfolgende Diagramm zeigt einen möglichen Verlauf des Ausgangsstromes I der steuerbaren Stromquelle 1. Der Strom I nimmt -ausgehend von einem maximalen Wert - kontinuierlich ab. Wie sich in Abhängigkeit von Strom I das Signal am Ausgang 6c ändert, zeigt das dritte Diagramm von oben ; d symbolisiert die jeweilige Ladezeit des Kondensators 7 bis zum Erreichen der halben Betriebsspannung. Das letzte Diagramm zeigt das zugehörige Signal am Ausgang 5c des UND-Gatters 5. Deutlich erkennbar ist die Veränderung des Tastverhältnisses vom Wert 0 für große Ladeströme I bis hin zum Wert 0,5 für kleine Ladeströme.

Ein Regelverstärker 2 und eine Referenzspannungsquelle 3 in Fig. 1 deuten eine vorteilhafte Verwendungsmöglichkeit des soweit beschriebenen Pulsbreitenmodulators an, nämlich seinen Einsatz im Regelkreis eines getakteten Gleichspannungswandlers. Die Ausgangsspannung des Regelverstärkers 2 steuert die steuerbare Stromquelle 1. Einem Eingang 2a des Regelverstärkers 2 wird die Regelgröße - hier die Ausgangsspannung des Wandlers oder eine dazu proportionale Spannung - zugeführt und einem Eingang 2b die Ausgangsspannung der Referenzspannungsquelle 3.

Auch der Regelverstärker 2 ist in CMOS-Technik erhältlich, z.B. als Low Power CMOS Operational Amplifier 7611, so daß die gesamte Schaltung nach Fig. 1 - obwohl die Referenzspannungsquelle 3 nicht in CMOS-Technik hergestellt werden kann - eine Verlustleistung aufweist, die noch unter 10 mW liegt. Die Schaltung ist außerdem integrierbar, und zwar so, daß CMOS-Bausteine und bipolare Bausteine auf einem Chip untergebracht sind.

Zur weiteren Reduzierung der Verlustleistung wird die Frequenz des Rechteckgenerators soweit herabgesetzt, daß sie gerade oberhalb der Hörschwelle liegt, z.B. bei 18 kHz. Das vermindert die Schaltvorgänge pro Zeiteinheit für alle beteiligten Bausteine und somit auch die mit den Schaltvorgängen verbundenen Verluste.

Die Eigenverlustleistung eines Gleichspannungswandlers kann mit einer Steuerschaltung nach Fig. 1 auf unter 25 mW herabgesetzt werden.

**Patentansprüche**

1. Pulsbreitenmodulator, bei dem durch ein Gatter (5) eine Rechteckschwingung mit festem Tastverhältnis und fester Frequenz proportional zur Größe eines Eingangssignals pulsbreitenmoduliert wird,
dadurch gekennzeichnet,
daß eine nachtriggerbare monostabile Kippschaltung (6) vorgesehen ist, deren Zeitglied aus einem Kondensator (7) besteht, der von einer durch das Eingangssignal gesteuerten Stromquelle (1) aufgeladen wird,
daß der Ausgang (4a) eines Rechteckgenerators (4) mit dem Triggereingang (6a) der monostabilen Kippschaltung (6) und mit einem Eingang (5a) des Gatters (5) verbunden ist und daß das Ausgangssignal der Kippschaltung (6) an den anderen Eingang (5b) des Gatters (5) geführt ist.

2. Pulsbreitenmodulator nach Anspruch 1, dadurch gekennzeichnet, daß die monostabile Kippschaltung (6) mit den fallenden Flanken der Rechteckschwingung getriggert wird und daß es sich bei dem Gatter (5) um ein UND-Gatter handelt.

3. Pulsbreitenmodulator nach Anspruch 1 oder 2, dadurch gekennzeichnet, daß es sich bei der steuerbaren Stromquelle (1) um einen pnp-Transistor mit Emitterwiderstand handelt, wobei der Kollektor des Transistors mit einem Anschluß des Kondensators verbunden ist und die Basis des Transistors vom Eingangssignal angesteuert wird.

4. Pulsbreitenmodulator nach einem der vorhergehenden Ansprüche, dadurch gekennzeichnet, daß das Eingangssignal die von einem Regelverstärker (2) gelieferte Stellgröße ist, wobei eine Eingangsspannung des Regelverstärkers die Regelgröße und die andere Eingangsspannung die von einer Referenzspannungsquelle (3) gelieferte Referenzspannung ist.

5. Pulsbreitenmodulator nach Anspruch 4,
dadurch gekennzeichnet,
daß der Regelverstärker (2), die Referenzspannungsquelle (3), der Rechteckgenerator (4), das Gatter (5), die

3

*m*onostabile Kippschaltung (6) und die steuerbare Stromquelle (1) monolithisch integriert sind.

6. Pulsbreitenmodulator nach Anspruch 4,
dadurch gekennzeichnet,
daß die monostabile Kippschaltung (6) der Rechteckgenerator (4), das Gatter (5) und der Regelverstärker (2) in CMOS-Technik ausgeführt sind.

7. Pulsbreitenmodulator nach einem der vorhergehenden Ansprüche,
dadurch gekennzeichnet,
daß die Frequenz des Rechteckgenerators (4) über der Hörschwelle liegt.

## Claims

1. A pulse-width modulator, wherein through a gate circuit (5) a square-wave oscillation having a fixed duty cycle and a fixed frequency is pulse-width modulated in proportion to the value of an input signal, characterized in that a retriggerable monostable multivibrator (6) is provided, whose timing element comprises a capacitor (7) charged by a current source (1) controlled by the input signal, in that the output signal (4a) of a square-wave generator (4) is applied to the trigger input (6a) of the monostable multivibrator (6) and to an input (5a) of the gate circuit (5) and in that the output signal of the multivibrator (6) is applied to the other input (5b) of the gate circuit (5).

2. A pulse-width modulator as claimed in claim 1, characterized in that the monostable multivibrator (6) is triggered by the falling edges of the square-wave oscillation and in that the gate 5 is an AND-gate.

3. A pulse-width modulator as claimed in claim 1 or 2, characterized in that the controllable current source (1) is a PNP-transistor with emitter resistance, the collector of the transistor being connected to a terminal of the capacitor and the base of the transistor being triggered by the input signal.

4. A pulse-width modulator as claimed in any one of the preceding claims, characterized in that the input signal is the setting quantity supplied by the differential gain amplifier (2), the input voltage of the differential gain amplifier being the controlling variable and the other input voltage being the reference voltage produced by a reference voltage source (3).

5. A pulse-width modulator as claimed in claim 4, characterized in that the differential gain amplifier (2), the reference voltage source (3), the square-wave generator (4), the gate circuit (5), the monostable multivibrator (6) and the controllable current source (1) are comprised in a monolithically integrated circuit.

6. A pulse-width modulator as claimed in claim 4, characterized in that the monostable multivibrator (6), the square-wave generator (4), the gate circuit (5) and the differential gain amplifier (2) are realized in CMOS-technology.

7. A pulse-width modulator as claimed in any one of the preceding claims, characterized in that the frequency of the square-wave generator (4) is above the hearing threshold.

## Revendications

1. Modulateur de largeur d'impulsions, dans lequel, à l'intervention d'un circuit-porte (5), une oscillation rectangulaire présentant un taux d'impulsions fixe et une fréquence fixe est modulée en largeur d'impulsions proportionnellement à la grandeur d'un signal d'entrée, caractérisé en ce qu'il est prévu une bascule monostable redéclenchable (6), dont le temporisateur consiste en un condensateur (7), qui est chargé par une source de courant (1) commandée par le signal d'entrée, que la sortie (4a) d'un générateur de signaux rectangulaires (4) est connectée à l'entrée de déclenchement (6a) de la bascule monostable (6) et à une entrée (5a) du circuit-porte (5) et que le signal de sortie de la bascule (6) est appliqué à l'autre entrée (5b) du circuit-porte (5).

2. Modulateur de largeur d'impulsions suivant la revendication 1, caractérisé en ce que la bascule monostable (6) est déclenchée par les flancs descendants de l'oscillation rectangulaire et que le circuit-porte (5) est une porte ET.

3. Modulateur de largeur d'impulsions suivant la revendication 1 ou 2, caractérisé en ce que la source de courant pouvant être commandée (1) est un transistor pnp à résistance d'émetteur, le collecteur du transistor étant connecté à une connexion du condensateur et la base du transistor étant pilotée par le signal d'entrée.

4. Modulateur de largeur d'impulsions suivant l'une quelconque des revendications précédentes, caractérisé en ce que le signal d'entrée est la variable de réglage fournie par un amplificateur de régulation (2), l'une des tensions d'entrée de l'amplificateur de régulation étant la variable de régulation et l'autre tension d'entrée étant la tension de référence fournie par une source de tension de référence (3).

5. Modulateur de largeur d'impulsions suivant la revendication 4, caractérisé en ce que l'amplificateur de régulation (2), la source de tension de référence (3), le générateur de signaux rectangulaires (4), le circuit-porte (5), la bascule monostable (6) et la source de courant pouvant être commandée (1) sont intégrés sous forme monolithique.

6. Modulateur de largeur d'impulsions suivant la revendication 4, caractérisé en ce que la bascule monostable (6), le générateur de signaux rectangulaires (4), le circuit-porte (5) et l'amplificateur de régulation (2) sont réalisés suivant la technique CMOS.

7. Modulateur de largeur d'impulsions suivant l'une quelconque des revendications précédentes, caractérisé en ce que la fréquence du générateur de signaux rectangulaires (4) se situe au-dessus du seuil d'audibilité.

Vcc

FIG.1

FIG.2